# EUROPÄISCHE PATENTSCHRIFT

(11) **EP 2 843 722 B1**
(45) Veröffentlichungstag und Bekanntmachung des Hinweises auf die Patenterteilung: **01.06.2016**
(21) Anmeldenummer: 14180143.1
(22) Anmeldetag: 07.08.2014
(51) Int. Cl.: H01L 41/047, F02M 51/06

(54) **Außenelektrode für ein piezokeramisches Vielschichtbauteil**
External electrode for a piezoceramic multilayer component
Électrode externe pour un composant piézo-céramique multicouche

(30) Priorität: 22.08.2013 DE 102013216628
(43) Veröffentlichungstag der Anmeldung: 04.03.2015
(73) Patentinhaber: ROBERT BOSCH GMBH, 70442 Stuttgart (DE)
(72) Erfinder: Buhr, Kai, 294182906 Charleston (US); Benes, Jan, 96047 Bamberg (DE)

(56) Entgegenhaltungen:
- WO-A1-2010/020643
- WO-A1-2011/154348
- DE-A1- 10 327 902
- DE-A1-102006 001 134

## Beschreibung

### Stand der Technik

Die Erfindung betrifft eine Außenelektrode für ein Vielschichtbauteil, ein piezokeramisches Vielschichtbauteil mit einer Außenelektrode und ein Brennstoffeinspritzventil mit einem piezoelektrischen Aktor, der aus einem piezokeramischen Vielschichtbauteil gebildet ist. Speziell betrifft die Erfindung das Gebiet der piezoelektrischen Aktoren für Brennstoffeinspritzventile von Brennkraftmaschinen.

Aus der DE 103 27 902 A1 ist eine Außenelektrode an einem piezokeramischen Vielschichtaktor bekannt. Die bekannte Außenelektrode besteht aus mindestens zwei Lagen eines leitenden Werkstoffs und einer dazwischen angeordneten Lage eines nicht leitenden Werkstoffs. Hierbei wird in der Nähe einer Aktorstirnfläche ein Lötpunkt für einen Anschlussdraht auf die Außenelektrode aufgebracht. Durch die Gestaltung der Außenelektrode kann der Anschluss der Spannungszuführung an die Außenelektrode verbessert werden. Hierbei ist die angelötete oder angeschweißte elektrische Kontaktierung nur mit der obersten leitenden Schicht verbunden. Dadurch wird ein Durchlöten der Schicht verhindert. Die Kontaktierung des Anschlussdrahtes an die äußere leitende Schicht der Außenelektrode wirkt sich nicht mehr versteifend auf die Elektrode aus.

Die aus der DE 103 27 902 A1 bekannte Außenelektrode hat den Nachteil, dass die zwischen den zwei leitenden Lagen angeordnete Lage aus dem nicht leitenden Werkstoff eine zusätzliche Lage darstellt, die mit zusätzlichen Kosten verbunden ist und den Herstellungsprozess aufwändiger gestaltet. Ferner hat diese Ausgestaltung den Nachteil, dass sich die Dicke der Außenelektrode durch die zusätzliche nicht leitende Lage vergrößert. In Bezug auf vorgegebene Außenabmessungen, insbesondere einen Gesamtquerschnitt des piezokeramischen Vielschichtaktors mit der Außenelektrode, verringert sich dadurch die Querschnittsfläche des piezokeramischen Materials. Somit verringert sich die Leistungsfähigkeit des Vielschichtaktors.

Aus der WO 2010/020643 A1 und DE 10 2006 001 134 A1 sind darüber hinaus Piezoaktoren mit Außenelektroden bekannt, die mehrschichtig aufgebaut sein können.

### Offenbarung der Erfindung

Die erfindungsgemäße Außenelektrode mit den Merkmalen des Anspruchs 1, das erfindungsgemäße piezokeramische Vielschichtbauteil mit den Merkmalen des Anspruchs 8 und das erfindungsgemäße Brennstoffeinspritzventil mit den Merkmalen des Anspruchs 9 haben den Vorteil, dass die Herstellbarkeit und die Funktionsfähigkeit verbessert sind. Durch die in den Unteransprüchen aufgeführten Maßnahmen sind vorteilhafte Weiterbildungen der im Anspruch 1 angegebenen Außenelektrode, des im Anspruch 8 angegebenen piezokeramischen Vielschichtbauteils und des im Anspruch 9 angegebenen Brennstoffeinspritzventils möglich.

Vorteilhaft ist es, dass sich der Spalt, der zwischen den Gewebestreifen der zweiten Lage gebildet ist, zumindest abschnittsweise entlang einer Längsachse der Außenelektrode erstreckt. Ferner ist es vorteilhaft, dass der Spalt zumindest in einem mittleren Abschnitt der Außenelektrode mittig in der zweiten Lage zwischen den Gewebestreifen ausgebildet ist. Hierdurch wird die Herstellung der Außenelektrode vereinfacht, da die Gewebestreifen eine ausreichende Breite aufweisen, um den Biegeprozess beziehungsweise das Falten des Gewebes zu ermöglichen. Ferner kann hierdurch eine vorteilhafte Kontaktierung von einem Teil der Innenelektrodenschichten eines Aktorkörpers erfolgen.

Das Vielschichtbauteil kann auch zwei Außenelektroden aufweisen, die sich in ihrem Aufbau entsprechen. Der Aktorkörper, der aus einer Vielzahl von keramischen Schichten und einer Vielzahl von zwischen den piezokeramischen Schichten angeordneten Innenelektrodenschichten aufgebaut ist, kann dadurch mit einer großen wirksamen Querschnittsfläche ausgestaltet werden. Hierbei können die Innenelektrodenschichten abwechselnd mit den beiden Außenelektroden kontaktiert werden. Bei einer abgewandelten Ausgestaltung kann allerdings auch eine Außenelektrode mit einer Innenelektrode kombiniert werden. Solch eine Innenelektrode, die stiftförmig ausgestaltet sein kann, kann sich beispielsweise senkrecht zu den Innenelektrodenschichten durch den Aktorkörper erstrecken.

Vorteilhaft ist es auch, dass die zweite Lage an dem Verbindungsbereich erfindungsgemäß eine Aussparung aufweist und/oder dass zumindest einer der Gewebestreifen der zweiten Lage an dem Verbindungsbereich eine Aussparung aufweist. Hierbei können auch beide Gewebestreifen eine Aussparung aufweisen. Bei dieser Ausgestaltung ist die Außenelektrode im Verbindungsbereich einlagig ausgestaltet, da aufgrund der Aussparung der zweiten Lage im Verbindungsbereich nur die erste Lage vorhanden ist. Beim Anbringen der elektrischen Zuleitung erfolgt somit nur eine Kontaktierung mit der ersten leitenden Lage. Dies erfolgt vorzugsweise durch Schweißen, wobei zur Verbesserung der Haftfestigkeit und der elektrischen Leitfähigkeit ein Lot zugegeben werden kann. Ein Einfluss des Spalts zwischen den Gewebestreifen auf die Ausgestaltung der Verbindung ist hierbei verhindert.

In vorteilhafter Weise hat die Aussparung einen Querschnitt, der auf einem Vieleck basiert. Ferner ist es vorteilhaft, dass die Gewebestreifen der zweiten leitenden Lage Ausschnitte aufweisen, die die Aussparung in der zweiten leitenden Lage an dem Verbindungsbereich bilden. Bei der Ausgestaltung der Ausschnitte können beispielsweise schneidende oder stanzende Verfahren zum Einsatz kommen. Somit ist eine einfache Herstellung des Gewebes möglich, das anschließend gefaltet wird, um die leitenden Lagen zu bilden. Nach dem Falten ergibt sich dann die Aussparung in der zweiten leitenden Lage aus den vorgesehenen Ausschnitten.

Außerdem ist es vorteilhaft, dass die Gewebestreifen der zweiten leitenden Lage so ausgestaltet sind, dass der zwischen den Gewebestreifen gebildete Spalt außermittig an dem Verbindungsbereich vorbeigeführt ist. Dadurch kann der Spalt beziehungsweise die im Bereich des Spaltes bestehende ungleichmäßige Geometrie, die eine ungleichmäßige Dicke des Gewebes zur Folge hat, die Verbindung der elektrischen Zuleitung an dem Gewebe nicht beeinträchtigen. Dennoch kann bei dieser Ausgestaltung ein zweilagiger Aufbau im Verbindungsbereich realisiert werden.

Hierbei ist es auch von Vorteil, dass der eine Gewebestreifen der zweiten leitenden Lage eine Aussparung aufweist, dass der andere Gewebestreifen der zweiten leitenden Lage eine Erweiterung aufweist, die sich in dem gefalteten Gewebe in die Aussparung des einen Gewebestreifens einfügt, und dass die Erweiterung des anderen Gewebestreifens in der zweiten leitenden Lage an dem Verbindungsbereich der ersten leitenden Lage angeordnet ist. Somit kann auf einfache Weise ein Gewebe hergestellt werden, das im gefalteten Zustand einen Versatz in dem Spalt zwischen den Gewebestreifen realisiert. In dem Verbindungsbereich kann dadurch ein zweilagiger Aufbau des Gewebes realisiert werden, der nicht durch den Spalt unterbrochen ist.

Vorteilhaft ist es auch, dass das Gewebe, aus dem die erste leitende Lage und die zweite leitende Lage gebildet sind, als Drahtgewebe ausgebildet ist. Ferner ist es vorteilhaft, dass das Gewebe als beschichtetes Gewebe ausgebildet ist. Beispielsweise kann das Drahtgewebe durch eine Ummantelung der einzelnen Drähte beschichtet sein.

Somit kann das piezokeramische Vielschichtbauteil in vorteilhafter Weise mit zumindest einer Außenelektrode versehen werden, die die elektrische Kontaktierung zu einzelnen Innenelektrodenschichten gewährleistet. Das Gewebe ist hierbei vorzugsweise doppellagig ausgestaltet. Allerdings sind auch mehrlagige Ausgestaltungen mit mehr als zwei Lagen denkbar. Der Spalt zwischen den Gewebestreifen kann hierbei außerhalb des Verbindungsbereichs mittig verlaufen, was sich unter anderem günstig auf die Herstellbarkeit auswirkt.

Die Kontaktierung der Zuleitung mit dem gefalteten Gewebe erfolgt vorzugsweise im fußseitigen Bereich bei einer mittigen Positionierung. Beispielsweise kann ein Pin oder dergleichen durch Schweißen, insbesondere Spaltschweißen, auf die erste leitende Lage des gefalteten Gewebes gefügt werden. Hierbei liegt der Verbindungsbereich und somit der Kontaktierungsbereich des Pins außerhalb des Spaltes. Somit wird eine gewisse Toleranz bei der Positionierung der elektrischen Zuleitung relativ zu der ersten leitenden Lage des gefalteten Gewebes ermöglicht, bei der stets eine gleichmäßige Dicke des Gewebes zur Kontaktierung zur Verfügung steht. Unterschiedlich starke Überlappungen des Pins mit dem Gewebe werden dadurch von vornherein verhindert. Somit kann die Verbindung der elektrischen Zuleitung mit dem Gewebe mit gleich bleibender Qualität realisiert werden.

Im Unterschied dazu ist bei einem mittig durch den Verbindungsbereich verlaufenden Siebspalt eine Eigenschaftsstreuung unvermeidbar, da die Eigenschaften der Pin-Kontaktierung maßgeblich von den Eigenschaften des Gewebes abhängen und somit abhängig davon sind, ob der Pin exakt mittig auf dem Siebspalt oder seitlich verschoben zum Siebspalt positioniert ist.

Insbesondere können somit die mechanische Haftfestigkeit und die elektrische Stromtragfähigkeit, vor allem über die Lebensdauer des Vielschichtbauteils, gewährleistet werden. Speziell kann somit ein vorzeitiger Ausfall des Vielschichtbauteils im Betrieb verhindert werden, da beispielsweise eine Dekontaktierung des Anschlusspins oder dergleichen aufgrund der gleichmäßigen Dicke des Gewebes und der dadurch bedingten gleichbleibenden Qualität der Kontaktierung verhindert ist.

Somit können eine Qualität der Kontaktierung der elektrischen Zuleitung mit dem Gewebe und reduzierte Anforderungen hinsichtlich Toleranzen bei der Positionierung der elektrischen Zuleitung an dem Gewebe erzielt werden. Insbesondere wirkt sich eine in der Praxis nicht zu vermeidende, leicht versetzte Positionierung eines Anschlusspins somit nicht ungünstig auf die Kontaktierung aus.

Somit kann ein mehrlagiges, insbesondere doppellagiges, Design der Außenelektrode realisiert werden, da es im Verbindungsbereich (Kontaktierungsbereich) einen einheitlichen Aufbau der beiden Lagen aufweist. Dies kann dadurch erzielt werden, indem sich in diesem Verbindungsbereich, der sich vorzugsweise auf der Mittelachse beziehungsweise einer Längsachse der Außenelektrode befindet, kein mittiger Siebspalt befindet.

Hierbei kann im Verbindungsbereich insbesondere ein einheitlich einlagiger Aufbau, in dem die zweite leitende Lage ausgespart ist, oder ein einheitlich doppellagiger Aufbau durch einen versetzten Spalt (Siebspalt) ausgestaltet werden.

Bei einer möglichen Ausgestaltung ergibt sich somit der Vorteil, dass bei der Kontaktierung eines Anschlussdrahtes oder dergleichen der elektrischen Zuleitung im hierfür vorgesehenen Verbindungsbereich des gefalteten Gewebes ein einheitlicher Aufbau des doppellagigen Gewebes vorliegt. Damit kann eine gleich bleibende Qualität der Kontaktierung bei Positionsabweichungen des Anschlussdrahtes oder dergleichen sichergestellt werden.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigen:
Fig. 1 ein Brennstoffeinspritzventil mit einem als piezoelektrischen Aktor ausgestalteten piezokeramischen Vielschichtbauteil in einer schematischen Darstellung entsprechend einem Ausführungsbeispiel;
Fig. 2 eine Außenelektrode des in Fig. 1 dargestellten piezokeramischen Vielschichtbauteils in einer schematischen Schnittdarstellung entlang der mit II bezeichneten Schnittlinie entsprechend dem Ausführungsbeispiel der Erfindung;
Fig. 3 die Außenelektrode des in Fig. 1 dargestellten piezokeramischen Vielschichtbauteils in einer schematischen Schnittdarstellung entlang der mit III bezeichneten Schnittlinie entsprechend dem Ausführungsbeispiel der Erfindung;
Fig. 4 ein Gewebe zur Herstellung der Außenelektrode gemäß dem Ausführungsbeispiel in einer schematischen Darstellung;
Fig. 5 eine Außenelektrode des in Fig. 1 dargestellten piezokeramischen Vielschichtbauteils in einer schematischen Darstellung entsprechend einem ergänzenden Beispiel;
Fig. 6 einen schematischen Schnitt durch die in Fig. 5 dargestellte Außenelektrode entlang der mit VI bezeichneten Schnittlinie entsprechend dem ergänzenden Beispiel und
Fig. 7 ein Gewebe zur Herstellung der Außenelektrode gemäß dem ergänzenden Beispiel in einer schematischen Darstellung.

### Auführungsform der Erfindung und ergänzendes Beispiel

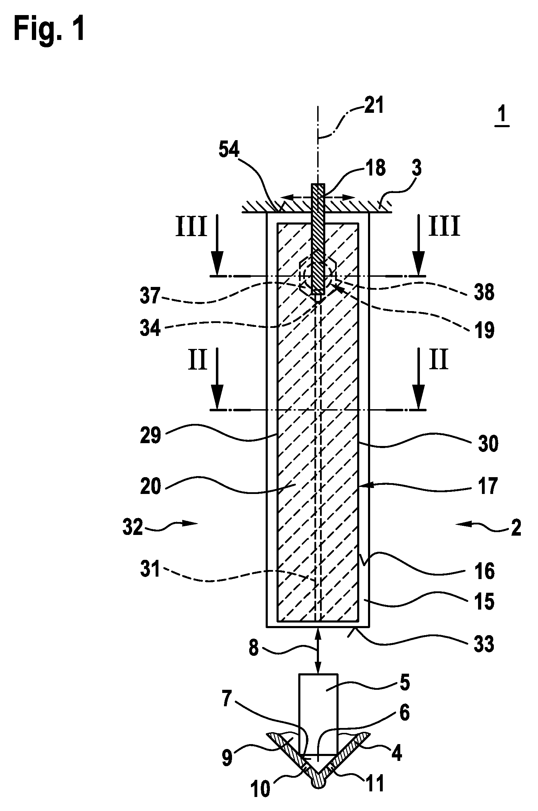

Fig. 1 zeigt ein Brennstoffeinspritzventil 1 mit einem piezokeramischen Vielschichtbauteil 2, das als piezoelektrischer Aktor 2 ausgebildet ist, in einer schematischen Darstellung entsprechend einem Ausführungsbeispiel. Das Brennstoffeinspritzventil 1 kann hierbei insbesondere zur direkten Einspritzung von Brennstoff in den Brennraum einer Brennkraftmaschine dienen. Speziell eignet sich das Brennstoffeinspritzventil 1 für gemischverdichtende, fremdgezündete Brennkraftmaschinen oder für luftverdichtende, selbstzündende Brennkraftmaschinen.

Bei einer entsprechenden Ausgestaltung eignet sich das Brennstoffeinspritzventil 1 jedoch auch für andere Anwendungsfälle. Ferner kann das piezokeramische Vielschichtbauteil 2 bei einer entsprechend angepassten Ausgestaltung auch für andere Anwendungszwecke dienen. Hierbei kann das piezokeramische Vielschichtbauteil 2 je nach Anwendungsfall als Aktor oder Sensor ausgestaltet sein.

Das Brennstoffeinspritzventil 1 weist ein Gehäuseteil 3 und einen Düsenkörper 4 auf. In dem Düsenkörper 4 ist eine Düsennadel 5 mit einem Ventilschließkörper 6 angeordnet. Der Ventilschließkörper 6 wirkt hierbei mit einer Ventilsitzfläche 7 des Düsenkörpers 4 zu einem Dichtsitz zusammen. Die Düsennadel 5 ist von dem piezoelektrischen Aktor 2 zumindest mittelbar betätigbar, was schematisch durch den Doppelpfeil 8 veranschaulicht ist. Bei einer Betätigung der Düsennadel 5 wird der zwischen dem Ventilschließkörper 6 und der Ventilsitzfläche 7 gebildete Dichtsitz geöffnet, so dass Brennstoff aus einem Brennstoffraum 9 im Inneren des Düsenkörpers 4 über Spritzlöcher 10, 11 in den Brennraum der Brennkraftmaschine eingespritzt werden kann.

Der piezoelektrische Aktor 2 weist einen als Aktorkörper 15 ausgestalteten Körper 15 auf, der eine Vielzahl von zwischen den keramischen Schichten angeordneten Innenelektrodenschichten umfasst. An einer Außenseite 16 des Aktorkörpers 15 ist eine Außenelektrode 17 angebracht. Hierbei kann an einer weiteren Außenseite, die beispielsweise von der Außenseite 16 abgewandt ist, eine weitere Außenelektrode vorgesehen sein, die entsprechend der Außenelektrode 17 ausgestaltet ist. Der piezoelektrische Aktor 2 weist außerdem eine elektrische Zuleitung 18 für die Außenelektrode 17 auf. Hierbei kann eine weitere Zuleitung vorgesehen sein, die für eine weitere Außenelektrode vorgesehen ist.

Die Außenelektrode 17 weist einen Verbindungsbereich 19 auf, in dem die Zuleitung 18 stoffschlüssig mit einem Gewebe 20 der Außenelektrode 17 verbunden ist. Diese stoffschlüssige Verbindung wird vorzugsweise durch Schweißen gebildet.

Die Außenelektrode 17 weist eine Längsachse 21 auf, die zugleich eine Mittelachse 21 des gefalteten Gewebes 20 darstellt.

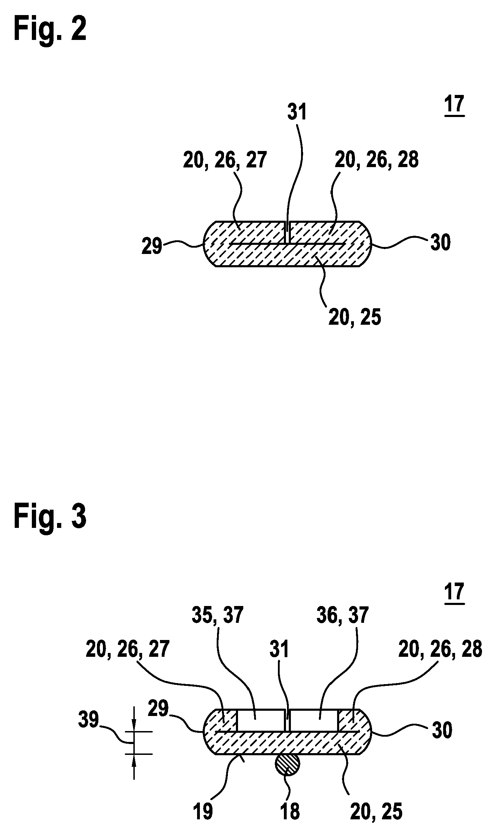

Fig. 2 zeigt die Außenelektrode 17 des in Fig. 1 dargestellten piezokeramischen Vielschichtbauteils 2 in einer schematischen Schnittdarstellung entlang der mit II bezeichneten Schnittlinie entsprechend dem Ausführungsbeispiel. Die Außenelektrode 17 weist eine erste leitende Lage 25 und eine zweite leitende Lage 26 auf, die aus dem gefalteten Gewebe 20 gebildet sind. Hierbei weist die zweite leitende Lage 26 Gewebestreifen 27, 28 auf, die über Biegefalze 29, 30 mit der ersten leitenden Lage 25 verbunden sind. Zwischen den Gewebestreifen 27, 28 ist ein Spalt 31 gebildet, der in den mittleren Abschnitt 32 der Außenelektrode 17 mittig in der zweiten Lage 26 ausgebildet ist und sich entlang der Längsachse 21 erstreckt. In diesem Ausführungsbeispiel erstreckt sich der Spalt 31 von einem Kopf (Aktorkopf) 33 bis zu einer Stelle 34 entlang der Längsachse 21 mittig durch die Außenelektrode 17.

Fig. 3 zeigt die Außenelektrode 17 des in Fig. 1 dargestellten piezokeramischen Vielschichtbauteils 2 in einer schematischen Schnittdarstellung entlang der mit III bezeichneten Schnittlinie entsprechend dem Ausführungsbeispiel. Der Gewebestreifen 27 weist einen Ausschnitt 35 auf. Der Gewebestreifen 28 weist einen Ausschnitt 36 auf. Durch die Ausschnitte 35, 36 der Gewebestreifen 27, 28 ist eine Aussparung 37 in der zweiten leitenden Lage 26 gebildet. Die Aussparung 37 ist an dem Verbindungsbereich 29 in der zweiten leitenden Lage 26 vorgesehen. In diesem Ausführungsbeispiel ist die Aussparung 37 in beiden Gewebestreifen 27, 28 der zweiten leitenden Lage 26 ausgestaltet.

Die Aussparung 37 weist einen Querschnitt 38 auf, der auf einem Vieleck basiert. In diesem Ausführungsbeispiel basiert der Querschnitt 38 auf einem Sechseck, wie es in der Fig. 1 veranschaulicht ist. Die Stelle 34 liegt hierbei an einer Ecke des Sechsecks beziehungsweise des Querschnitts 38.

Der Verbindungsbereich 19 befindet sich in der Projektion betrachtet innerhalb des Querschnitts 38 der zweiten leitenden Lage 26. Somit ist das Gewebe 20 im Bereich des Querschnitts 38 der Aussparung 37 und somit auch im Verbindungsbereich 19 einlagig ausgestaltet. Hierbei ist in dem Verbindungsbereich 19 eine gleichmäßige Dicke 39 des Gewebes 20 gegeben, die in diesem Ausführungsbeispiel gleich der Dicke 39 der ersten leitenden Lage 25 ist.

Durch die Aussparung 37 beziehungsweise die Ausschnitte 35, 36 sind die Gewebestreifen 27, 28 des Gewebes 20 daher so ausgestaltet, dass an dem Verbindungsbereich 19 eine gleichmäßige Dicke 39 des Gewebes 20 gegeben ist.

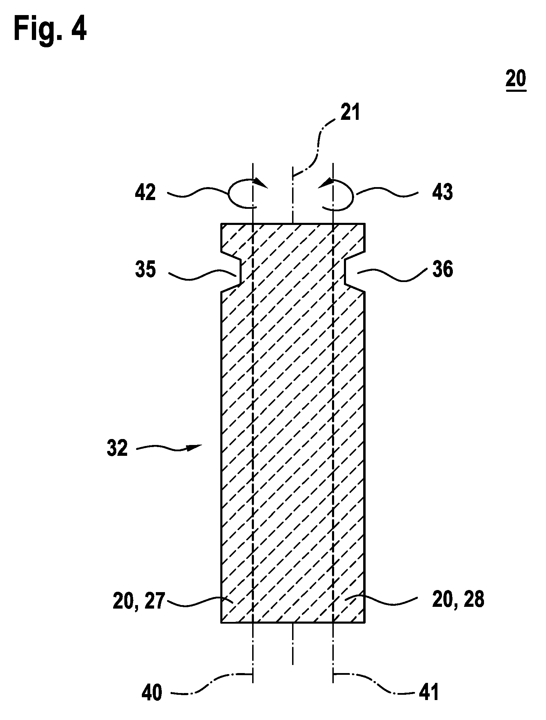

Fig. 4 zeigt das Gewebe 20 zur Herstellung der Außenelektrode 17 gemäß dem Ausführungsbeispiel in einer schematischen Darstellung. Hierbei sind die Ausschnitte 35, 36 beispielsweise durch Stanzen in dem Gewebe 20 ausgestaltet. Anschließend werden die Gewebestreifen 27, 28 um die Biegelinien 40, 41, die parallel zu der Längsachse 21 verlaufen, gebogen, wie es durch die Pfeile 42, 43 veranschaulicht ist. Die zweite leitende Lage 26 ist dann durch die Gewebestreifen 27, 28 des gefalteten Gewebes 20 gebildet. An den Biegelinien 40, 41 des Gewebes 20 sind dann die Biegefalze 29, 30 gebildet. Die Ausschnitte 35, 36 der Gewebestreifen 27, 28 bilden die Aussparung 37 der zweiten Lage 26. Ferner bildet sich zwischen den ungefalteten Gewebestreifen 27, 28 abschnittsweise der Spalt 31 in der zweiten Lage 26.

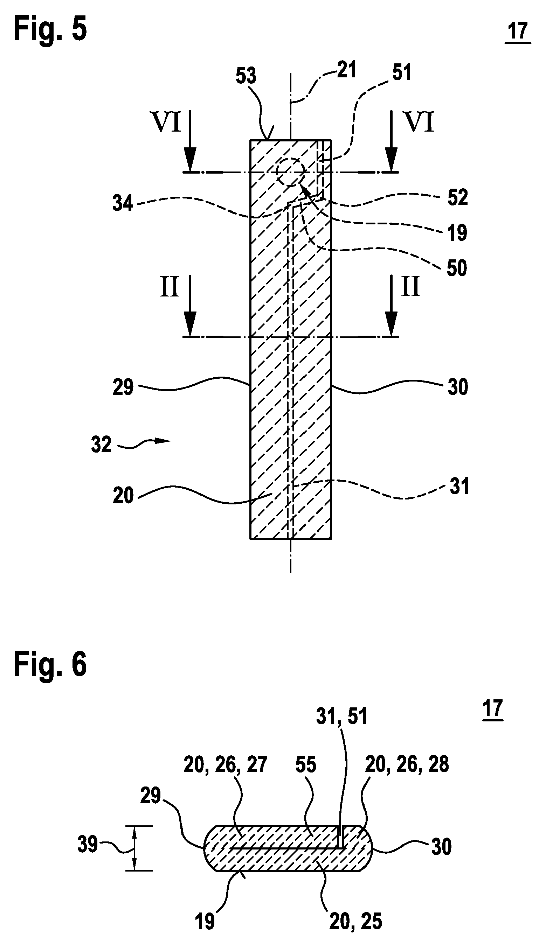

Fig. 5 zeigt eine Außenelektrode 17 des in Fig. 1 dargestellten piezokeramischen Vielschichtbauteils 2 in einer schematischen Darstellung entsprechend einem ergänzenden Beispiel außerhalb der Erfindung. In diesem ergänzenden Beispiel außerhalb der Erfindung weist der Spalt 31 Abschnitte 50, 51 auf, die an dem Verbindungsbereich 19 vorbeiführen. Der Abschnitt 50 des Spalts 31 erstreckt sich hierbei von der Stelle 34, die mittig in der Außenelektrode 17 und somit auf der Längsachse 21 liegt, zu einer Stelle 52, die außermittig angeordnet ist. Der Abschnitt 51 erstreckt sich parallel zu der Längsachse 21 von der Stelle 52 bis zu einem Ende 53 der Außenelektrode 17, das nach dem Aufbringen auf die Außenseite 16 des Aktorkörpers 15 an einem Aktorfuß 54 des Aktorkörpers 15 liegt.

In dem mittleren Abschnitt 32 ist die Außenelektrode 17 entsprechend der Außenelektrode 17 des Ausführungsbeispiels ausgestaltet. Ein Schnitt durch den mittleren Abschnitt 32 der Außenelektrode 17 entlang der mit II bezeichneten Schnittlinie entspricht daher einem Schnitt, wie er anhand der Fig. 2 veranschaulicht ist.

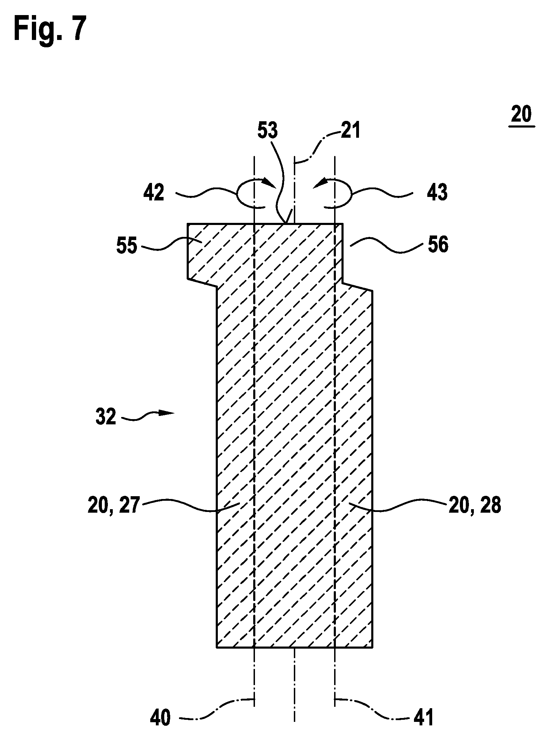

Fig. 6 zeigt einen schematischen Schnitt durch die in Fig. 5 dargestellte Außenelektrode 17 entlang der mit II bezeichneten Schnittlinie entsprechend dem ergänzenden Beispiel. Hierbei sind die Gewebestreifen 27, 28 so ausgestaltet, dass der zwischen den Gewebestreifen 27, 28 gebildete Spalt 31 außermittig an dem Verbindungsbereich 19 vorbeigeführt ist. Hierfür weist der Gewebestreifen 27 eine Erweiterung 55 auf, die sich in dem gefalteten Gewebe 20 in eine Aussparung 56 (Fig. 7) des Gewebestreifens 28 einfügt. Die Erweiterung 55 des Gewebestreifens 27 in der zweiten leitenden Lage 26 ist hierbei an dem Verbindungsbereich 19 der ersten leitenden Lage 25 angeordnet.

Die Dicke 39 des Gewebes 20 im Verbindungsbereich 19 ergibt sich somit aus der Gesamtdicke 39 der beiden Lagen 25, 26 des Gewebes 20. An dem Verbindungsbereich 19 ist hierbei eine gleichmäßige Dicke 39 des Gewebes 20 gegeben, da der Spalt 31 außermittig an dem Verbindungsbereich 19 vorbeigeführt ist. Somit sind die Gewebestreifen 27, 28 der zweiten Lage 26 des Gewebes 20 so ausgestaltet, dass an dem Verbindungsbereich 19 die gleichmäßige Dicke 39 des Gewebes 20 gegeben ist.

Fig. 7 zeigt das Gewebe 20 zur Herstellung der Außenelektrode 17 gemäß dem ergänzenden Beispiel in einer schematischen Darstellung. Das Gewebe 20 mit der Erweiterung 55 und der Aussparung 56 kann hierbei beispielsweise durch Stanzen hergestellt werden. Die Gewebestreifen 27, 28 sind insbesondere im mittleren Abschnitt 32 symmetrisch ausgestaltet. Durch die Erweiterung 55 und die Aussparung 56 ergibt sich am Ende 53 eine asymmetrische Ausgestaltung des Gewebes 20. Durch diese asymmetrische Ausgestaltung des Gewebes 20 ist der Spalt 31 im Verbindungsbereich 19 asymmetrisch versetzt angeordnet, wenn das Gewebe 20 entsprechend gefaltet ist.

Die Außenelektrode 17 gemäß dem ergänzenden Beispiel hat den Vorteil, dass die Bauteilmasse der Außenelektrode 17 und damit das mechanische und elektrische Verhalten sowie gegebenenfalls die Gesamtmenge einer möglichen Siebbeschichtung bei gleichem Draht- und/oder Gewebeaufbau weitgehend gleich zu einem gefalteten Gewebe mit durchgehendem Spalt ist. Ferner kann gegebenenfalls eine Kontaktierung von Innenelektrodenschichten auch im Bereich des Endes 53 über die größere Anlagefläche der zweiten leitenden Lage 26 an der Außenseite 16 des Aktors 15 verbessert werden.

Das Gewebe 20, aus dem die erste leitende Lage 25 und die zweite leitende Lage 26 gebildet sind, kann als beschichtetes Gewebe 20 ausgebildet sein. Hierbei kommt insbesondere eine auf Lot basierende Beschichtung in Frage. Speziell kann ein Überzug der Drähte des Drahtgewebes mit Lot vorgesehen sein.

Die Erfindung ist nicht auf die beschriebenen Ausführungsbeispiele beschränkt, sondern wird durch die Ansprüche definiert.

## Patentansprüche

1. Außenelektrode (17) für ein Vielschichtbauteil (2) mit einer ersten leitenden Lage (25) und zumindest einer zweiten leitenden Lage (26), die aus einem gefalteten Gewebe (20) gebildet sind, wobei die erste leitende Lage (25) einen Verbindungsbereich (19) aufweist, in dem eine Zuleitung (18) stoffschlüssig mit zumindest der ersten leitenden Lage (25) verbindbar ist, wobei die zweite leitende Lage (26) Gewebestreifen (27, 28) aufweist, die durch das gefaltete Gewebe (20) ausgestaltet sind, und wobei zwischen den Gewebestreifen (27, 28) der zweiten leitenden Lage (26) zumindest ein Spalt (31) gebildet ist,
wobei die Gewebestreifen (27, 28) der zweiten leitenden Lage (26) so ausgestaltet sind, dass an dem Verbindungsbereich (19) eine gleichmäßige Dicke (39) des Gewebes (20) gegeben ist,
**dadurch gekennzeichnet, dass**
die zweite leitende Lage (26) an dem Verbindungsbereich (19) eine Aussparung (37) aufweist und/oder dass zumindest einer der Gewebestreifen (27, 28) der zweiten leitenden Lage (26) an dem Verbindungsbereich (19) eine Aussparung (37) aufweist, wobei die Außenelektrode (17) aufgrund der Aussparung (37) im Verbindungsbereich (19) einlagig ausgestaltet ist.

2. Außenelektrode nach Anspruch 1,
**dadurch gekennzeichnet,**
**dass** sich der Spalt (31) zumindest abschnittsweise entlang einer Längsachse (21) erstreckt und/oder dass der Spalt (31) zumindest in einem mittleren Abschnitt (32) zumindest näherungsweise mittig in der zweiten leitenden Lage (26) ausgebildet ist.

3. Außenelektrode nach Anspruch 1,
**dadurch gekennzeichnet,**
**dass** die Aussparung (37) einen Querschnitt (38) aufweist, der auf einem Vieleck basiert.

4. Außenelektrode nach einem der Ansprüche 1 bis 3,
**dadurch gekennzeichnet,**
**dass** die Gewebestreifen (27, 28) der zweiten leitenden Lage (26) Ausschnitte (35, 36) aufweisen, die eine Aussparung (37) in der zweiten leitenden Lage (26) an dem Verbindungsbereich (19) bilden.

5. Außenelektrode nach Anspruch 1 oder 2,
**dadurch gekennzeichnet,**
**dass** die Gewebestreifen (27, 28) der zweiten leitenden Lage (26) so ausgestaltet sind, dass der zwischen den Gewebestreifen (27, 28) gebildete Spalt (31) außermittig an dem Verbindungsbereich (19) vorbeigeführt ist.

6. Außenelektrode nach Anspruch 5,
**dadurch gekennzeichnet,**
**dass** der eine Gewebestreifen (28) der zweiten leitenden Lage (26) eine Aussparung (56) aufweist, dass der andere Gewebestreifen (27) der zweiten leitenden Lage (26) eine Erweiterung (55) aufweist, die sich in dem gefalteten Gewebe (20) in die Aussparung (56) des einen Gewebestreifens (28) einfügt, und dass die Erweiterung (55) des anderen Gewebestreifens (27) in der zweiten leitenden Lage (26) an dem Verbindungsbereich (19) der ersten leitenden Lage (25) angeordnet ist.

7. Außenelektrode nach einem der Ansprüche 1 bis 6,
**dadurch gekennzeichnet,**
**dass** das Gewebe (20), aus dem die erste leitende Lage (25) und die zweite leitende Lage (26) gebildet sind, als Drahtgewebe (20) ausgebildet ist und/oder dass das Gewebe (20) als beschichtetes Gewebe (20) ausgebildet ist.

8. Piezokeramisches Vielschichtbauteil (2), insbesondere piezokeramischer Aktor (2), mit einem Körper (15) und zumindest einer an einer Außenseite (16) des Körpers (15) angebrachten Außenelektrode (17), die nach einem der Ansprüche 1 bis 8 ausgebildet ist.

9. Brennstoffeinspritzventil (1), insbesondere Injektor für Brennkraftmaschinen, mit einem piezokeramischen Vielschichtbauteil (2) nach Anspruch 9, das als piezokeramischer Aktor (2) ausgestaltet ist.

## Claims

1. External electrode (17) for a multilayer component (2) with a first conductive ply (25) and with at least one second conductive ply (26) which are formed from a folded fabric (20), wherein the first conductive ply (25) has a connecting region (19) in which a supply line (18) can be cohesively connected to at least the first conductive ply (25), wherein the second conductive ply (26) has fabric strips (27, 28) which are formed by the folded fabric (20), and wherein at least one gap (31) is formed between the fabric strips (27, 28) of the second conductive ply (26),
wherein the fabric strips (27, 28) of the second conductive ply (26) are formed such that a uniform thickness (39) of the fabric (20) is realized at the connecting region (19),
**characterized in that**
the second conductive ply (26) has a recess (37) at the connecting region (19), and/or **in that** at least one of the fabric strips (27, 28) of the second conductive ply (26) has a recess (37) at the connecting region (19), wherein the external electrode (17) is of single-ply form owing to the recess (37) in the connecting region (19).

2. External electrode according to Claim 1,
**characterized**
**in that** the gap (31) extends at least in sections along a longitudinal axis (21), and/or in that the gap (31) is, at least in a central section (32), formed at least approximately centrally in the second conductive ply (26).

3. External electrode according to Claim 1,
**characterized**
**in that** the recess (37) has a cross section (38) based on a polygonal shape.

4. External electrode according to one of Claims 1 to 3,
**characterized**
**in that** the fabric strips (27, 28) of the second conductive ply (26) have cutouts (35, 36) which form a recess (37) in the second conductive ply (26) at the connecting region (19).

5. External electrode according to Claim 1 or 2,
**characterized**
**in that** the fabric strips (27, 28) of the second conductive ply (26) are formed such that the gap (31) formed between the fabric strips (27, 28) is led eccentrically past the connecting region (19).

6. External electrode according to Claim 5,
**characterized**
**in that** one of the fabric strips (28) of the second conductive ply (26) has a recess (56), in that the other fabric strip (27) of the second conductive ply (26) has an extension (55) which, in the folded fabric (20), protrudes into the recess (56) of the former fabric strip (28), and in that the extension (55) of the other fabric strip (27) is arranged in the second conductive ply (26) at the connecting region (19) of the first conductive ply (25).

7. External electrode according to one of Claims 1 to 6,
**characterized**
**in that** the fabric (20) from which the first conductive ply (25) and the second conductive ply (26) are formed is in the form of a wire fabric (20) and/or in that the fabric (20) is in the form of a coated fabric (20).

8. Piezoceramic multilayer component (2), in particular piezoceramic actuator (2), having a body (15) and having at least one external electrode (17) attached to an outer side (16) of the body (15), which external electrode is designed according to one of Claims 1 to 8.

9. Fuel injection valve (1), in particular injector for internal combustion engines, having a piezoceramic multilayer component (2) according to Claim 9, which component is designed as a piezoceramic actuator (2).

## Revendications

1. Électrode extérieure (17) pour un composant multicouche (2) comprenant une première couche conductrice (25) et au moins une deuxième couche conductrice (26), lesquelles sont constituées d'un tissu plié (20), la première couche conductrice (25) possédant une zone de liaison (19) dans laquelle une ligne d'arrivée (18) peut être reliée par fusion de matières au moins avec la première couche conductrice (25), la deuxième couche conductrice (26) possédant des bandes de tissu (27, 28) qui sont façonnées par le tissu plié (20), et au moins un interstice (31) étant formé entre les bandes de tissu (27, 28) de la deuxième couche conductrice (26),
les bandes de tissu (27, 28) de la deuxième couche conductrice (26) étant façonnées de telle sorte qu'une épaisseur (39) homogène du tissu (20) est obtenue au niveau de la zone de liaison (19),
**caractérisée en ce que**
la deuxième couche conductrice (26) possède une cavité (37) au niveau de la zone de liaison (19) et/ou **en ce qu'**au moins l'une des bandes de tissu (27, 28) de la deuxième couche conductrice (26) possède une cavité (37) au niveau de la zone de liaison (19), l'électrode extérieure (17) étant façonnée d'une seule couche en raison de la cavité (37) dans la zone de liaison (19).

2. Électrode extérieure selon la revendication 1, **caractérisée en ce que** l'interstice (31) s'étend au moins dans certaines portions le long d'un axe longitudinal (21) et/ou **en ce que** l'interstice (31), au moins dans une portion centrale (32), est formé au moins approximativement au centre dans la deuxième couche conductrice (26).

3. Électrode extérieure selon la revendication 1, **caractérisée en ce que** la cavité (37) possède une section transversale (38) qui se base sur un polygone.

4. Électrode extérieure selon l'une des revendications 1 à 3, **caractérisée en ce que** les bandes de tissu (27, 28) de la deuxième couche conductrice (26) possèdent des découpes (35, 36) qui forment une cavité (37) dans la deuxième couche conductrice (26) au niveau de la zone de liaison (19).

5. Électrode extérieure selon la revendication 1 ou 2, **caractérisée en ce que** les bandes de tissu (27, 28) de la deuxième couche conductrice (26) sont façonnées de telle sorte que l'interstice (31) formé entre les bandes de tissu (27, 28) passe de manière excentrée au niveau de la zone de liaison (19).

6. Électrode extérieure selon la revendication 5, **caractérisée en ce qu'**une bande de tissu (28) de la deuxième couche conductrice (26) possède une cavité (56), **en ce que** l'autre bande de tissu (27) de la deuxième couche conductrice (26) possède une extension (55) qui, dans le tissu (20) plié, vient s'insérer dans la cavité (56) de l'une bande de tissu (28), et **en ce que** l'extension (55) de l'autre bande de tissu (27) dans la deuxième couche conductrice (26) est disposée au niveau de la zone de liaison (19) de la première couche conductrice (25).

7. Électrode extérieure selon l'une des revendications 1 à 6, **caractérisée en ce que** le tissu (20) duquel sont formées la première couche conductrice (25) et la deuxième couche conductrice (26) est réalisé sous la forme d'un tissu de fil métallique (20) et/ou en ce que le tissu (20) est réalisé sous la forme d'un tissu enrobé (20).

8. Composant multicouche piézocéramique (2), notamment actionneur piézocéramique (2), comprenant un corps (15) et au moins une électrode extérieure (17) montée sur un côté extérieur (16) du corps (15), laquelle est configurée selon l'une des revendications 1 à 8.

9. Injecteur de combustible (1), notamment injecteur pour moteurs à combustion interne, comprenant un composant multicouche piézocéramique (2) selon la revendication 9 qui est réalisé sous la forme d'un actionneur piézocéramique (2).
